Europäisches Patentamt

European Patent Office

Office européen des brevets

(11) Publication number: **0 172 016 B1**

# EUROPEAN PATENT SPECIFICATION

(45) Date of publication of patent specification: **22.07.92**    (51) Int. Cl.5: **G06F 11/20**

(21) Application number: **85305728.9**

(22) Date of filing: **13.08.85**

(54) Semiconductor memory device having a redundancy circuit.

(30) Priority: **14.08.84 JP 168772/84**

(43) Date of publication of application:
**19.02.86 Bulletin 86/08**

(45) Publication of the grant of the patent:
**22.07.92 Bulletin 92/30**

(84) Designated Contracting States:
**DE FR GB**

(56) References cited:
**EP-A- 0 030 245**
**GB-A- 2 129 585**
**US-A- 4 125 875**

**IBM TECHNICAL DISCLOSURE BULLETIN, vol. 24, no. 9, February 1982, pages 4776-4778, New York, US; F.J. AICHELMANN, Jr. et al.: "Dynamic allocation of redundant memory components"**

**Idem, vol. 13, no. 7, December 1970, pages 1880-1881, New York, US; W.K. HOFFMAN : "Redundancy scheme for shift register memory"**

**IBM TECHNICAL DISCLOSURE BULLETIN, vol. 13, no. 7, December 1970, pages 1880-1881,**

**New York, US; W.K. HOFFMAN: "Redundancy scheme for shift register memory"**

(73) Proprietor: **FUJITSU LIMITED
1015, Kamikodanaka Nakahara-ku
Kawasaki-shi Kanagawa 211(JP)**

(72) Inventor: **Ogawa, Junji
1-8-17-207 Minamisenzoku
Ota-ku Tokyo 145(JP)**

(74) Representative: **Sunderland, James Harry et al
HASELTINE LAKE & CO Hazlitt House 28
Southampton Buildings Chancery Lane
London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor memory device, more particularly to a semiconductor memory device having a redundancy circuit.

There is known a semiconductor memory device consisting of a combination of a random-access memory (RAM) and a shift register group. This type of semiconductor memory device is, in general, used as an image memory. The shift register group is attached to the RAM for high-speed read-out of the data stored therein. The RAM is, for example, provided between a central processing unit (CPU) and a cathode-ray tube display (CRT). The data stored in the RAM is read out in parallel to the shift registers in accordance with control of a system. The read-out data is output serially from the shift register group to the CRT.

IBM T.D.B., Vol. 24, No. 9, pp 4776-8, discloses a system for dynamic allocation of redundant memory components in a multiple-bit-output memory device, having features corresponding to those of the preamble of accompanying claim 1. A defective memory array element and its associated I/O circuitry are replaced as a whole by a redundant memory array element and I/O circuity; thereafter, defective data is blocked and replaced by data from the redundant memory array element before reaching a data bus.

EP-A-0 030 245 by the present applicant discloses a random access memory device with provision for replacing a defective memory cell by a redundant memory cell. However, this memory device does not include a serial output means and therefore does not provide redundancy control of a serial output mode.

IBM T.D.B., Vol. 13, No. 7, pp 1880-1, discloses a redundancy scheme for a shift register memory, including a so-called reconfiguring shift register which stores information identifying a defective memory shift register. The data intended for the defective memory shift register is handled by a redundant memory shift register.

Even in view of the above disclosures, there is still no known RAM having both random access and serial data output functions and a redundancy function.

According to the present invention, there is provided a semiconductor memory device comprising:-

a memory cell array having a plurality of regular columns and at least one redundancy column, for replacing a defective one of said regular columns; and

serial output means for reading out data from said regular and redundant columns in parallel and serially outputting the read-out data;

characterised in that:-

the memory device is a random-access memory device having random-access input and output means, operatively connected to said memory cell array, for inputting data and outputting data from a selected one of the regular or redundant columns;

said serial output means being operatively connected to said memory cell array independently of said random-access input and output means, whereby the memory device is operable either in a random access mode or a serial output mode; and in that

redundancy control means are provided, operatively connected to said serial output means and responsive to the address of defective one of said plurality of regular columns for replacing data of said defective one of said plurality of regular columns, after it has been read out by said serial output means, with data from said at least one redundancy column.

The embodiment of the present invention provides a semiconductor memory device which enables both low-speed random access by a CPU and high-speed serial data transmission between RAM and a CRT. It also provides a circuit giving a redundancy function to a semiconductor memory device. Such a redundancy circuit enables an increase of the yield in production of semiconductor memory devices.

The embodiment of the present invention provides a semiconductor memory device having a serial output means for high-speed read-out of data and a redundancy circuit for raising the yield.

Reference is made, by way of example, to the accompanying drawings in which:

Fig. 1 is a schematic block diagram of a semiconductor memory device according to an embodiment of the present invention;

Fig. 2 is a schematic block diagram of a semiconductor memory device according to another embodiment of the present invention;

Fig. 3 is a schematic block diagram of a semiconductor memory device according to another embodiment of the present invention; and

Fig. 4 is a schematic block diagram of a semiconductor memory device according to still another embodiment of the present invention.

A semiconductor memory device according to an embodiment of the present invention will be explained in detail with reference to the accompanying drawings.

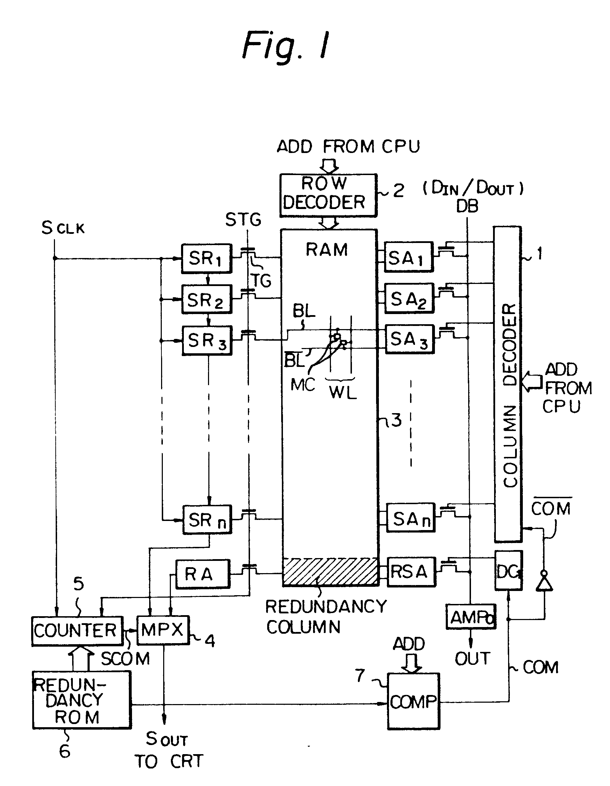

Figure 1 is a schematic block diagram of a semiconductor memory device according to an embodiment of the present invention. In Fig. 1, reference numeral 1 represents a column decoder, 2 a row decoder, 3 an image memory (RAM), 4 a multiplexer, 5 a counter, 6 a redundancy read-only memory (redundancy ROM), and 7 a comparator. Reference letters $SA_1$ to $SA_n$ represent sense am-

plifiers, RSA a redundancy sense amplifier, $DC_1$ a drive circuit, $SR_1$ to $SR_n$ shift registers, and RA a redundancy amplifier. In the RAM 3, MC is a memory cell connected between word lines WL and bit lines BL, $\overline{BL}$. The bit lines BL are connected to the corresponding shift registers $SR_3$ through the transfer gate TG, and the word lines WL are connected to the row decoder 2. The slanted line portion in the RAM 3 indicates a redundancy column (column of redundant cells).

In this embodiment, a redundancy circuit is constituted by the drive circuit $DC_1$ , the redundancy sense amplifier RSA, the redundancy amplifier RA, the multiplexer 4, the counter 5, the redundancy ROM 6, and the comparator 7.

In the inspection of the manufacture of the RAM, when a defective column is found, the column address indicating the defective column is stored in the redundancy ROM and the redundancy ROM is enabled. That is, the redundancy ROM 6 is enabled to provide the column address (or addresses) corresponding to the defective column (or columns) of the RAM 3. Storage of the defective column address in the redundancy ROM 6 may be performed by cutting a polycrystalline silicon fuse.

There are two known methods for cutting a polycrystalline silicon fuse, i.e., one utilizing a laser beam and another method utilizing electrical current.

A semiconductor memory device according to the present invention basically operates such that, when a defective column in the RAM is accessed by an address ADD sent from the CPU, this defective column is replaced by a redundancy column in the RAM, indicated by slanted lines in Figure 1. That is, an area of the memory is reserved for the redundancy function. Accordingly, even if a defective column is found in the RAM, the device can operate as a normal memory.

The operation of tie device of Figure 1 will now be explained in detail.

If a defect is found in the column corresponding to, for example, the sense amplifier $SA_2$ , the corresponding column address is stored in the redundancy ROM 6.

In the random access mode, in read-out when the input address ADD from the CPU is applied to the column decoder 1 and the comparator 7, if no defective column address is included in the input address, data corresponding to the input address is output from the RAM to the data bus DB through the corresponding sense amplifiers and output from the amplifier $AMP_0$. In writing, write data corresponding to the input address is input to the RAM from the data bus DB.

Assume a defective column address corresponding to the sense amplifier $SA_2$ is included in the input address. The comparator 7 compares the input column addresses with the stored defective column address in the redundancy ROM 6. As one of the input column addresses coincides with the stored defective column address, a coincidence signal COM is input to the drive circuit $DC_1$ and an inverted coincidence signal $\overline{COM}$ is input to the column decoder 1. When the coincidence signal COM is input to the drive circuit $DC_1$ , the drive circuit $DC_1$ activates the redundancy sense amplifier RSA for use of the redundancy column. Accordingly, data from the data bus DB is read out from or written to the RAM using the redundancy column instead of the defective column.

In the serial output mode, data stored in the RAM is simultaneously read out in parallel to the shift registers $SR_1$ to $SR_n$ through the transfer gates TG. Accordingly, data corresponding to the defective column is also read out to one of the shift registers, for example, to the shift register $SR_2$. Each shift register sequentially transfers the input data to the next shift register every clock signal $S_{CLK}$. Finally, the input data is shifted to the final shift register $SR_n$ and input to the multiplexer 4. Data corresponding to the redundancy column, i.e., the correct data, is latched in the redundancy amplifier RA. When the data corresponding to the defective column, i.e., the defective data, is shifted to the multiplexer 4, that is, the data of the shift register $SR_2$ is transferred to the multiplexer 4 through the shift register $SR_n$ , the multiplexer 4 replaces the defective data with the correct data latched in the redundancy amplifier RA for output to the CRT. Accordingly, correct serial outputs $S_{OUT}$ can be obtained at a high speed.

The data replacement operation in the multiplexer 4 will be explained in more detail below.

As mentioned above, the defective column address is previously stored in the redundancy ROM 6. That is, the number of the defective column counted from the final column (final shift register $SR_n$) is also stored in the redundancy ROM 6. The number of columns between the final column and the defective column is read out from the redundancy ROM 6 and input to the counter 5. Accordingly, the counter 5 is initially set to that number of columns after it is preset by the transfer gate signal STG.

The clock signal $S_{CLK}$ is input to the counter 5 and input in parallel to the shift registers $SR_1$ to $SR_n$. The counter 5 subtracts one from the number of columns every clock signal $S_{CLK}$. At the same time, the data in each shift register is shifted to the next shift register every clock signal $S_{CLK}$. When the count becomes "0", the counter 5 outputs a coincidence signal SCOM to the multiplexer 4. At this time, since the defective data shifted by the shift registers arrives at the multiplexer 4, the multiplexer 4 can replace the defective data with the correct data based on the coincidence signal SCOM. Accordingly, serial output of the correct data can be obtained from the multiplexer 4 and transmitted to the CRT.

When the transfer gate control signal STG is ON, all transfer gates TG are simultaneously turned ON so as to transfer the data in the RAM in parallel to the shift registers $SR_1$ to $SR_n$.

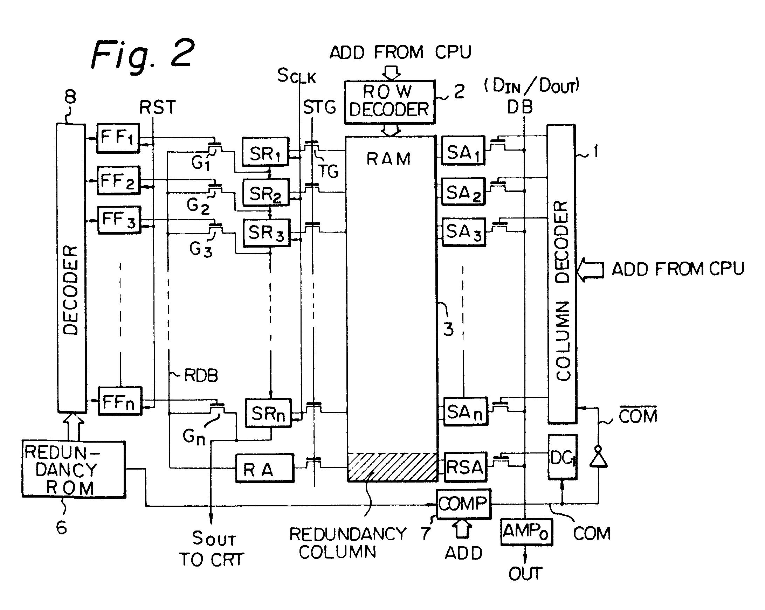

Figure 2 is a schematic block diagram of a semiconductor memory device according to another embodiment of the present invention. In Fig. 2, the same reference numerals and letters as in Fig. 1 indicate the same elements. In this embodiment, a decoder 8, flip-flop circuits $FF_1$ to $FF_n$ , gates $G_1$ to $G_n$ , and data bus RDB are provided instead of the multiplexer 4 and the counter 5 shown in Fig. 1.

As mentioned above, the defective column address is previously stored in the redundancy ROM 6.

In this embodiment, in the random access mode, the same read/write operations of the redundancy column as the redundancy column shown in Fig. 1 are performed. Accordingly, explanations of the operations will be omitted.

In the serial output mode, when data corresponding to the defective column is read out from the RAM to one of the shift registers, for example, to the shift register $SR_2$ , the defective data is compulsorily replaced by the correct data sent from the redundancy amplifier RA through the redundancy data bus RDB and the gate $G_2$ in the first next shift operation. That is, information regarding the defective column address stored in the redundancy ROM 6 is applied to the decoder 8. The decoder sets the corresponding flip-flop circuit. In this case, the flip-flop circuit $FF_2$ is set by the decoder 8. Since all flip-flop circuits $FF_1$ to $FF_n$ have been reset in the initial state, only the flip-flop circuit $FF_2$ is set, and the corresponding gate $G_2$ is turned ON by the output of the flip-flop circuit $FF_2$. Other gates $G_1$ and $G_3$ to $G_n$ are turned OFF.

Accordingly, as explained above, the correct data latched in the redundancy amplifier RA is sent to the output of the shift register $SR_2$ through the data bus RDB and the defective data is replaced with the correct data. Consequently, the correct serial outputs can be obtained from the final shift register $SR_n$ and transmitted to the CRT.

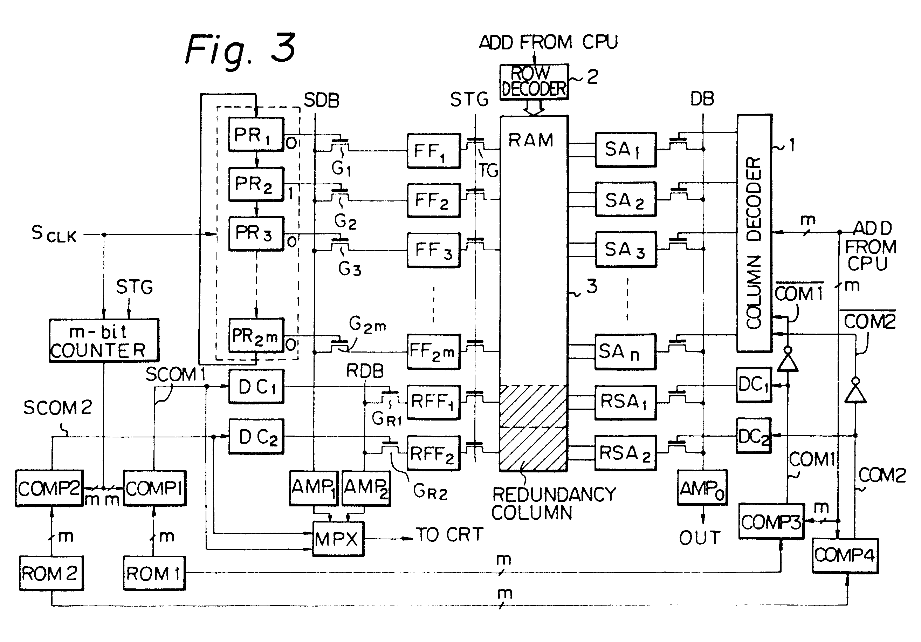

Figure 3 is a schematic block diagram of a semiconductor memory device according to another embodiment of the present invention. In this case, a new redundancy column (slanted lines portion in the Figure) is added to the memory area in the RAM 3. As can be understood, the yield of devices can be raised by the addition of the new redundancy column over the single redundancy column shown in Figs. 1 and 2. In Fig. 3, reference letter m represents an m-bit address.

With the addition of the new redundancy column, the redundancy sense amplifier $RSA_2$ , the drive circuit $DC_2$ , the comparator COMP4, and the redundancy ROM 2 are newly added to the redundancy circuit.

In the same way as explained above, a second defective column address is previously stored in the redundancy ROM 2. Of course, the first defective column address is previously stored in the redundancy ROM 1.

In this embodiment, in the random access mode, the same read/write operations of the redundancy columns as the redundancy column shown in Fig. 1 are performed. Accordingly, explanation of the operations will be omitted.

Reference letters $PR_1$ to $PR_2m$ represent so-called pointers functioning as a ring counter in the serial output mode. Reference letters $FF_1$ to $FF_2m$ represent flip-flop circuits. These pointers and flip-flop circuits perform the same function as the shift register group shown in Figs. 1 and 2. Each of the pointers $PR_1$ to $PR_2m$ can shift the signal "1" in response to the clock signal $S_{CLK}$. That is, the signal "1" is sequentially shifted from the first pointer $PR_1$ to the final pointer $PR_2m$. Accordingly, only one pointer at a time becomes "1". The other pointers become "0". In this case, a preset means may be provided in order to preset the pointer $PR_1$ so as to become "1" as the start position of the serial operation. When a pointer becomes "1", the corresponding gate is turned ON and the data latched in the flip-flop circuit is read out through a shift data bus SDB. Accordingly, the data in the RAM is sequentially read out through the shift data bus SDB by the sequential turning ON of each gate in response to the signal "1" of the pointer.

If defective data is latched in the flip-flop circuit $FF_2$ for example, then when the pointer $PR_2$ becomes "1", the gate $G_2$ is turned ON and the defective data is sent to the multiplexer MPX through an amplifier $AMP_1$. Also, when the pointer $PR_2$ becomes "1", the gate $G_{R1}$ is turned ON by the coincidence signal SCOM1 sent from a comparator COMP1. Accordingly, the correct data latched in a redundancy flip-flop circuit $RFF_1$ is read out to an amplifier $AMP_2$ through the gate $G_{R1}$ and the redundancy data bus RDB. Since the coincidence signal SCOM1 is simultaneously input to the multiplexer MPX, the multiplexer MPX can replace the defective data with the correct data.

In this case, as explained in Fig. 1, the coincidence signal SCOM1 is generated when the comparator COMP1 compares the number of the defective column address stored in the redundancy ROM 1 with the number of the m-bit counter and detects coincidence therebetween. The m-bit counter is preset by the transfer gate signal STG.

As can be understood, the same explanations apply to the second redundancy column using the redundancy ROM 2, a comparator COMP2, and a coincidence signal SCOM2.

This method using pointers can reduce power consumption compared with the method using shift registers shown in Figs. 1 and 2. This is because each shift register must sequentially transfer data to the next shift register. Conversely, only one selected pointer and flip-flop need transfer data to the output.

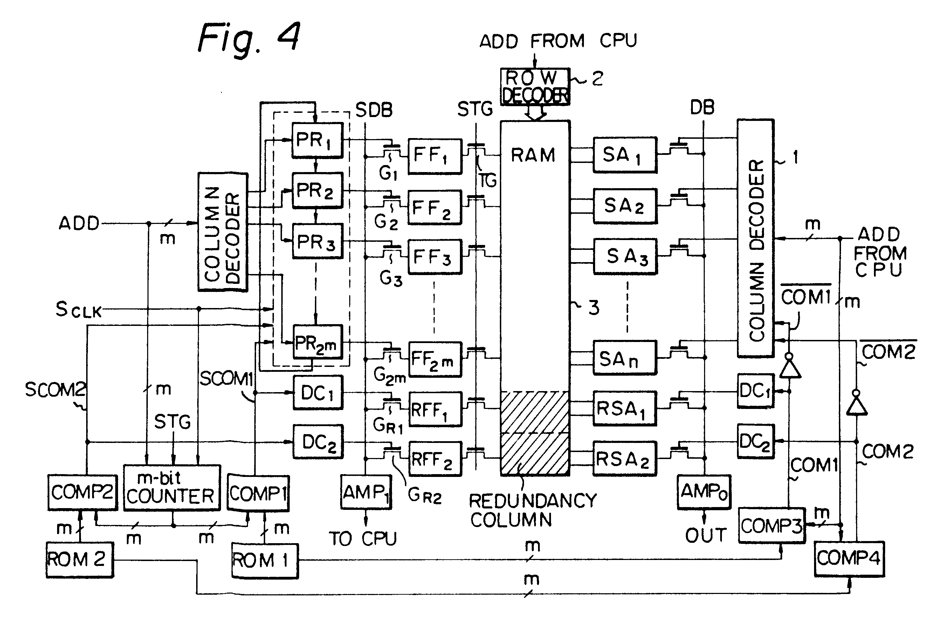

Figure 4 is a schematic block diagram of a semi-conductor memory device according to still another embodiment of the present invention. In Fig. 4, the same structure as that of Fig. 3 is applied for the random access mode.

In the serial output mode, the shift data bus SDB is used instead of a redundancy data bus RDB. Accordingly, the redundancy data bus RDB is eliminated and the redundancy flip-flop circuits $RFF_1$ and $RFF_2$ are connected to the shift data bus SDB through the gates $G_{R1}$ and $G_{R2}$.

In this embodiment, the gate corresponding to the defective data, for example, the gate $G_2$, is not turned ON since the corresponding pointer $PR_2$ does not output the signal "1". In this case, all pointers become "0" because the clock signal $S_{CLK}$ is not applied to them (for instance by means of the signals SCOM1, SCOM2). Alternatively, the gate $G_{R1}$ is turned ON at the same time based on the coincidence signal SCOM1 explained above, so that the correct data latched in the redundancy flip-flop circuit $RFF_1$ is output to the amplifier $AMP_1$ through the gate $G_{R1}$ and the shift data bus SDB. Regarding the pointers coupled with the column decoder, since the start position of the signal "1" pointer can be arbitrarily selected by the column decoder, the corresponding gate can be turned ON so that the data stored in the RAM can be read out from the corresponding column. That is, an arbitrary head address can be designated by the pointer. This is advantageous for so-called "scrolling" of the image data. As can be understood, similar advantages to the embodiment shown in Fig. 3 are obtained by this embodiment.

## Claims

1. A semiconductor memory device comprising:-
   a memory cell array (3) having a plurality of regular columns and at least one redundancy column, for replacing a defective one of said regular columns; and
   serial output means for reading out data from said regular and redundant columns in parallel and serially outputting the read-out data;
   characterised in that:-

the memory device is a random-access memory device having random-access input and output means (1, 2, $SA_1$, ..., $SA_n$, RSA, DB), operatively connected to said memory cell array, for inputting data and outputting data from a selected one of the regular or redundant columns;
   said serial output means being operatively connected to said memory cell array independently of said random-access input and output means, whereby the memory device is operable either in a random access mode or a serial output mode; and in that
   redundancy control means are provided, operatively connected to said serial output means and responsive to the address of a defective one of said plurality of regular columns for replacing data of said defective one of said plurality of regular columns after it has been read out by said serial output means, with data from said at least one redundancy column.

2. A semiconductor memory device as claimed in claim 1, wherein said serial output means comprises:-
   a plurality of flip-flop circuits ($FF_1$, $FF_2$, ...,$FF_2m$; fig.3), operatively connected to said memory cell array (3), for latching the data read out from said memory cell array (3);
   a data bus (SDB, fig.3) for outputting said read-out data sequentially;
   a plurality of gates ($G_1$, $G_2$, ..., $G_2m$, fig.3), operatively connected between said data bus (SDB, fig.3) and said plurality of flip-flop circuits ($FF_1$, $FF_2$, ...$FF_2m$, fig. 3) for transferring said read-out data latched in said plurality of flip-flop circuits; and
   a plurality of pointers ($PR_1$, $PR_2$, ...$PR_2m$, fig.3), mutually connected in a ring and each connected to a corresponding one of said gates ($G_1$, $G_2$, ...$G_2m$, fig.3), one of said pointers containing a predetermined signal which is transferred around the pointers in turn, so as to activate each one of said gates ($G_1$, $G_2$, ...$G_2m$, fig.3) sequentially.

3. A semiconductor memory device as claimed in claim 2, further comprising a redundancy flip-flop circuit ($RFF_1$, $RFF_2$, fig.3), operatively connected between said redundancy column and said data bus (SDB, fig.3), for latching data read out from said at least one of said redundancy column.

4. A semiconductor memory device as claimed in claim 2, further comprising:-
   at least one redundancy flip-flop circuit

(RFF$_1$, RFF$_2$, fig.3), operatively connected to said at least one of said redundancy columns, for latching data read out from said at least one of said redundancy columns; and

a redundancy data bus (RDB, fig.3), operatively connected to said redundancy flip-flop circuit (RFF$_1$, (RFF$_2$, fig.3), for outputting said read-out data latched therein.

5.  A semiconductor memory device as claimed in claim 2, 3 or 4, wherein a start position of said predetermined signal in said pointers (PR$_1$, PR$_2$, ...PR$_2$m, fig.3) is arbitrarily selected.

6.  A semiconductor memory device as claimed in claim 1, wherein said redundancy control means comprises:-

a read-only memory (6, fig.2) for storing a defective column address;

latching means (RA, fig.2), operatively connected to said at least one redundancy column, for latching the data read out from said at least one redundancy column;

a decoder (8, fig.2), operatively connected to said read-only memory (6, fig.2), for decoding said defective column address;

a plurality of flip-flop circuits (FF$_1$, FF$_2$, ..., FF$_m$, fig.2 operatively connected to said decoder (8, fig.2), for receiving outputs of said decoder;

a plurality of gates (G$_1$, G$_2$, ..., G$_m$,fig.2), operatively connected to corresponding ones of said flip-flop circuits (FF$_1$, FF$_2$, ...FF$_m$, fig.2), selectively turned on in accordance with the outputs of said flip-flop circuits; and

a data bus (RDB, fig.2), operatively connected to said plurality of gates (G$_1$, G$_2$, ...,G$_m$, fig.2) and to said latching means (RA, Fig.2), for replacing data of said defective column with the data of said at least one redundancy column.

7.  A semiconductor memory device as claimed in claim 1, wherein said redundancy control means comprises:-

a read-only memory (6, fig.1) for storing a defective column address;

latching means (RA, fig.1), operatively connected to said at least one redundancy column, for latching data read out of said at least one redundancy column;

a counter (5, fig.1), operatively connected to said read-only memory (6, fig.1) and operatively connected to receive a clock signal (S$_{clk}$), for counting the clock signal and outputting a coincidence signal (SCOM, fig.1) when the number in said counter corresponds to a column number indicating said defective column; and

a multiplexer (4, fig.1), operatively connected to said counter (5, fig.1), for replacing data in said defective column with data in said at least one redundancy column upon receipt of said coincidence signal (SCOM, fig.1).

**Revendications**

1.  Dispositif de mémoire à semiconducteur,comprenant:

une matrice de cellules de mémoire (3) comportant une pluralité de colonnes régulières et au moins une colonne de redondance, pour remplacer une colonne défectueuse parmi lesdites colonnes régulières; et

un moyen de sortie en série pour lire des données en parallèle dans lesdites colonnes régulières et redondantes et sortir en série les données lues;

caractérisé en ce que:

le dispositif de mémoire est un dispositif de mémoire à accès sélectif comportant des moyens d'entrée et de sortie d'accès sélectif (1,2,SA$_1$,..., SA$_n$,RSA,DB), connectés activement à ladite matrice de cellules de mémoire, pour entrer des données et sortir des données dans et d'une colonne sélectionnée parmi les colonnes régulières ou redondantes;

ledit moyen de sortie en série étant connecté activement à ladite matrice de cellules de mémoire indépendamment desdits moyens d'entrée et de sortie d'accès sélectif, le dispositif de mémoire pouvant ainsi être mis en fonctionnement soit dans un mode d'accès sélectif, soit dans un mode de sortie en série; et en ce que

des moyens de commande par redondance sont fournis, connectés activement audit moyen de sortie en série et réagissant à l'adresse d'une colonne défectueuse parmi ladite pluralité de colonnes régulières pour remplacer les données de ladite colonne défectueuse de ladite pluralité de colonnes régulières, après qu'elles aient été lues par ledit moyen de sortie en série, par des données de ladite au moins colonne de redondance.

2.  Dispositif de mémoire à semiconducteur selon la revendication 1, dans lequel ledit moyen de sortie en série comprend:

une pluralité de circuits à bascule (FF$_1$,FF$_2$,..., FF$_2$m,Figure 3), connectés activement à ladite matrice de cellules de mémoire (3) pour verrouiller les données lues dans ladite matrice de cellules de mémoire (3);

un bus de données (SDB, Figure 3) pour sortir séquentiellement lesdites données lues;

une pluralité de portes (G$_1$,G$_2$,...,G$_2$m, Figure 3), connectées activement entre ledit bus de données (SDB, Figure 3) et ladite pluralité de circuits à bascule (FF$_1$,FF$_2$,...,FF$_2$m, Figure 3) pour transférer lesdites données lues verrouillées dans ladite pluralité de circuits à bascule; et

une pluralité de circuits pointeurs (PR$_1$,PR$_2$,..., PR$_2$m,Figure 3), connectés entre eux en anneau et connectés chacun à une porte correspondante desdites portes (G$_1$,G$_2$,...,G$_2$m, Figure 3), un desdits circuits pointeurs contenant un signal prédéterminé qui est transféré successivement dans les circuits pointeurs en anneau, de manière à rendre active séquentiellement chacune desdites portes (G$_1$,G$_2$,...,G$_2$m,Figure 3).

3. Dispositif de mémoire à semiconducteur selon la revendication 2, comprenant en outre un circuit à bascules de redondance (RFF$_1$,RFF$_2$,Figure 3), connecté activement entre ladite colonne de redondance et ledit bus de données (SDB, Figure 3), pour verrouiller les données lues dans ladite au moins colonne de redondance.

4. Dispositif de mémoire à semiconducteur selon la revendication 2, comprenant en outre:

au moins un circuit à bascules de redondance (RFF$_1$, RFF$_2$, Figure 3), connecté activement à ladite au moins desdites colonnes de redondance pour verrouiller les données lues dans ladite au moins desdites colonnes de redondance ; et

un bus de données de redondance (RDB, Figure 3), connecté activement audit circuit à bascules de radondance (RFF$_1$,RFF$_2$,Figure 3), pour sortir lesdites données lues verrouillées dans celui-ci.

5. Dispositif de mémoire à semiconducteur selon l'une quelconque des revendications 2 à 4, dans lequel une position de début dudit signal prédéterminé dans lesdits circuits pointeurs (PR$_1$,PR$_2$,..., PR$_2$m,Figure 3) est sélectionnée arbitrairement.

6. Dispositif de mémoire à semiconducteur selon la revendication 1, dans lequel lesdits moyens de commande par redondance comprennent:

une mémoire morte (6,Figure 2) pour mémoriser une adresse de colonne défectueuse;

des moyens de verrouillage (RA, Figure 2),connectés activement à ladite au moins colonne de redondance, pour verrouiller les données lues dans ladite au moins colonne de redondance;

un décodeur (8, Figure 2), connecté activement à ladite mémoire morte (6,Figure 2), pour décoder ladite adresse de colonne défectueuse;

une pluralité de circuits à bascule (FF$_1$,FF$_2$,..., FF$_n$,Figure 2), connectés activement audit décodeur (8,Figure 2) pour recevoir les signaux de sortie dudit décodeur;

une pluralité de portes (G$_1$,G$_2$,...,G$_n$,Figure 2), connectées activement aux circuits correspondants desdits circuits à bascule (FF$_1$,FF$_2$,...,FF$_n$,Figure 2), rendus sélectivement conducteurs selon les signaux de sortie desdits circuits à bascule; et

un bus de données (RDB, Figure 2), connecté activement à ladite pluralité de portes (G$_1$,G$_2$,...,G$_n$,Fig.2) et auxdits moyens de verrouillage (RA,Figure 2), pour remplacer les données de ladite colonne défectueuse par les données de ladite au moins colonne de redondance.

7. Dispositif de mémoire à semiconducteur selon la revendication 1, dans lequel lesdits moyens de commande par redondance comprennent:

une mémoire morte (6,Fig.1) pour mémoriser une adresse de colonne défectueuse;

des moyens de verrouillage (RA, Figure 1), connectés activement à ladite au moins colonne de redondance, pour verrouiller les données lues dans ladite au moins colonne de redondance;

un compteur (5,Figure 1), connecté activement à ladite mémoire morte (6,Figure 1) et connecté activement pour recevoir un signal d'horloge (S$_{CLK}$), pour compter les signaux d'horloge et sortir un signal de coïncidence (SCOM, Figure 1) quand le nombre dans ledit compteur correspond à un numéro de colonne indiquant ladite colonne défecteuse; et

un multiplexeur (4, Figure 1), connecté activement audit compteur (5,Figure 1), pour remplacer les données de ladite colonne défectueuse par les données de ladite au moins colonne de redondance lors de la réception dudit signal de coïncidence (SCOM, Figure 1).

**Patentansprüche**

1. Eine Halbleiterspeichereinrichtung mit:-

einer Speicherzellenanordnung (3) mit einer Vielzahl von regulären Spalten und mindestens einer Redundanzspalte zum Ersetzen einer defekten der genannten regulären Spalten; und

einem seriellen Ausgabemittel zum Auslesen von Daten parallel aus den genannten regulären und redundanten Spalten und zum seriellen Ausgeben der ausgelesenen Daten;

dadurch gekennzeichnet, daß:-

die Speichereinrichtung eine Speichereinrichtung mit wahlfreiem Zugriff ist, welche Eingabe- und Ausgabemittel mit wahlfreiem Zugriff ($1$, $2$, $SA_1$, ..., $SA_n$, RSA, DB) hat, die mit der genannten Speicherzellenanordnung zum Eingeben von Daten und zum Ausgeben von Daten aus einer von den regulären oder redundanten Spalten ausgewählten Spalte operativ verbunden sind;

wobei das genannte serielle Ausgabemittel mit der genannten Speicherzellenanordnung unabhängig von den genannten Eingabe- und Ausgabemitteln mit wahlfreiem Zugriff operativ verbunden ist, wodurch die Speichereinrichtung entweder im wahlfreiem Zugriffsmodus oder im seriellen Ausgabemodus betriebsfähig ist; und dadurch, daß

Redundanzsteuermittel vorhanden sind, die mit dem genannten seriellen Ausgabemittel operativ verbunden sind und auf die Adresse einer defekten Spalte aus der genannten Vielzahl von regulären Spalten ansprechen, um Daten der genannten defekten Spalte aus der genannten Vielzahl von regulären Spalten, nachdem sie durch das genannte serielle Ausgabemittel ausgelesen worden sind, durch Daten von der genannten mindestens einen Redundanzspalte zu ersetzen.

2. Eine Halbleiterspeichereinrichtung nach Anspruch 1, bei welcher das genannte serielle Ausgabemittel umfaßt:-

eine Vielzahl von Flipflop-Schaltungen ($FF_1$, $FF_2$, ..., $FF_2m$; Fig. 3), welche mit der genannten Speicherzellenanordnung (3) zum Verriegeln der von der genannten Speicherzellenanordnung (3) ausgelesenen Daten operativ verbunden sind;

einen Datenbus (SDB, Fig. 3) zum sequentiellen Ausgeben der genannten ausgelesenen Daten;

eine Vielzahl von Gattern ($G_1$, $G_2$, ..., $G_2m$, Fig. 3), welche zwischen dem genannten Datenbus (SBD, Fig. 3) und der genannten Vielzahl von Flipflop-Schaltungen ($FF_1$, $FF_2$, ..., $FF_2m$, Fig. 3) zum Übertragen der genannten ausgelesenen Daten, welche in der genannten Vielzahl von Flipflop-Schaltungen verriegelt sind, operativ verbunden sind; und

eine Vielzahl von Hinweisadressen ($PR_1$, $PR_2$, ..., $PR_2m$, Fig. 3), die ringförmig miteinander verbunden und jeweils mit einem entsprechenden der genannten Gatter ($G_1$, $G_2$, ... $G_2m$, Fig. 3) verbunden sind, wobei eine der genannten Hinweisadressen ein vorberestimmtes Signal enthält, welches reihum an die Hinweisadressen übertragen wird, um jedes der genannten Gatter ($G_1$, $G_2$, ..., $G_2m$, Fig. 3) sequentiell zu aktivieren.

3. Eine Halbleiterspeichereinrichtung nach Anspruch 2, welche ferner eine Redundanz-Flipflop-Schaltung ($RFF_1$, $RFF_2$, Fig. 3) umfaßt, die zwischen der genannten Redundanzspalte und dem genannten Datenbus (SDB, Fig. 3) zum Verriegeln der aus der genannten mindestens einen der genannten Redundanzspalten ausgelesenen Daten operativ verbunden ist.

4. Eine Halbleiterspeichereinrichtung nach Anspruch 2, welche ferner umfaßt:-

mindestens eine Redundanz-Flipflop-Schaltung ($RFF_1$, $RFF_2$, Fig. 3), welche mit der genannten mindestens einen der genannten Redundanzspalten zum Verriegeln der aus der genannten mindestens einen der genannten Redundanzspalten ausgelesenen Daten operativ verbunden ist; und

einen Redundanzdatenbus (RDB, Fig. 3), welcher mit der genannten Redundanz-Flipflop-Schaltung ($RFF_1$, $RFF_2$, Fig. 3) für das Ausgeben der genannten ausgelesenen, darin verriegelten Daten operativ verbunden ist.

5. Eine Halbleiterspeichereinrichtung nach Anspruch 2, 3 oder 4, bei welcher eine Startposition des genannten vorherbestimmten Signals in den genannten Hinweisadressen ($PR_1$, $PR_2$, ... $PR_2m$, Fig. 3) willkürlich ausgewählt wird.

6. Eine Halbleiterspeichereinrichtung nach Anspruch 1, bei welcher das genannte Redundanzsteuermittel umfaßt:-

einen Nur-Lese-Speicher (6, Fig. 2) für das Speichern einer defekten Spaltenadresse;

ein Verriegelungsmittel (RA, Fig. 2), das mit der genannten mindestens einen Redundanzspalte für das Verriegeln der aus der genannten mindestens einen Redundanzspalte ausgelesenen Daten operativ verbunden ist;

einen Dekoder (8, Fig. 2), der mit dem genannten Nur-Lese-Speicher (6, Fig. 2) für das Dekodieren der genannten defekten Spaltenadresse operativ verbunden ist;

eine Vielzahl von Flipflop-Schaltungen ($FF_1$, $FF_2$, ..., $FF_n$, Fig. 2), die mit dem genannten Dekoder (8, Fig. 2) für das Empfangen von Ausgaben des genannten Dekoders operativ verbunden sind;

eine Vielzahl von Gattern ($G_1$, $G_2$, ... $G_n$, Fig. 2), die mit entsprechenden der genannten Flipflop-Schaltungen ($FF_1$, $FF_2$, ..., $FF_n$, Fig. 2) operativ verbunden sind, die in Übereinstimmung mit den Ausgängen der genannten Flipflop-Schaltungen selektiv eingeschaltet werden; und

einen Datenbus (RDB, Fig. 2), der mit der genannten Vielzahl von Gattern (G$_1$, G$_2$, ..., G$_n$, Fig. 2) und dem genannten Verriegelungsmittel (RA, Fig. 2) zum Ersetzen von Daten der genannten defekten Spalte durch die Daten der genannten mindestens einen Redundanzspalte operativ verbunden ist.

7. Eine Halbleiterspeichereinrichtung nach Anspruch 1, bei welcher das genannte Redundanzsteuermittel umfaßt:-

einen Nur-Lese-Speicher (6, Fig. 1) für das Speichern einer defekten Spaltenadresse;

ein Verriegelungsmittel (RA, Fig. 1), welches mit der genannten mindestens einen Redundanzspalte für das Verriegeln der von der mindestens einen Redundanzspalte ausgelesenen Daten operativ verbunden ist;

einen Zähler (5, Fig. 1), der mit dem genannten Nur-Lese-Speicher (6, Fig. 1) operativ verbunden ist, und zum Empfangen eines Taktsignals (S$_{clk}$) operativ verbunden ist, für das Zählen des Taktsignals und das Ausgeben eines Koinzidenzsignals (SCOM, Fig. 1), wenn die Nummer in dem genannten Zähler einer Spaltennummer, welche die genannte defekte Spalte anzeigt, entspricht; und

einen Multiplexer (4, Fig. 1), der mit dem genannten Zähler (5, Fig. 1) für das Ersetzen von Daten in der genannten defekten Spalte durch Daten in der genannten mindestens einen Redundanzspalte bei Empfang des genannten Koinzidenzsignals (SCOM, Fig. 1) operativ verbunden ist.

# Fig. I

## Fig. 2

Fig. 3

ADD FROM CPU

Fig. 4